# EUROPÄISCHE PATENTSCHRIFT

(11) **EP 2 131 129 B1**
(45) Veröffentlichungstag und Bekanntmachung des Hinweises auf die Patenterteilung: **29.04.2015**
(21) Anmeldenummer: 09007133.3
(22) Anmeldetag: 28.05.2009
(51) Int. Cl.: F26B 21/02, F26B 21/06, H05K 3/22

(54) **Vorrichtung zur Trocknung, insbesondere zur vorherigen Reinigung, Spülung und anschließenden Trocknung, von insbesondere im Wesentlichen flächigen Gegenständen**
Device for drying, in particular for prior cleaning, rinsing and subsequent drying, of particularly mostly flat objects
Dispositif de séchage, notamment de nettoyage et de rinçage préalable et de séchage subséquent, d'objets notamment essentiellement plats

(30) Priorität: 02.06.2008 DE 202008007337 U
(43) Veröffentlichungstag der Anmeldung: 09.12.2009
(73) Patentinhaber: kolb Cleaning Technology GmbH, 47877 Willich (DE)
(72) Erfinder: Pollmann, Georg, 47877 Willich (DE)
(74) Vertreter: DR. STARK & PARTNER

(56) Entgegenhaltungen:
- WO-A1-93/01892
- WO-A2-2010/055281
- GB-A- 774 309
- US-A- 3 518 772
- US-A- 5 819 437
- US-B1- 6 268 012

## Beschreibung

Die Erfindung betrifft eine Vorrichtung zur Trocknung, insbesondere zur vorherigen Reinigung, Spülung und anschließenden Trocknung, von insbesondere im Wesentlichen flächigen Gegenständen, mit einem eine Prozesskammer bildenden Gehäuse, das zumindest einen Trocknungslufteinlass und zumindest einen Trocknungsluftauslass aufweist, mit wenigstens einer Heizeinrichtung und mit wenigstens einer Luftfördereinrichtung.

Bekannte Vorrichtungen weisen ein Gehäuse auf, in dem die zu reinigenden Gegenstände üblicherweise vertikal in geeigneten Halterungen, wie z.B. Reinigungskörben, angeordnet sind. Bei den Gegenständen kann es sich beispielsweise um Siebschablonen, die zur Herstellung von Leiterplatten verwendet werden, oder um mit Bauteilen bestückte Leiterplatten handeln. Es sind aber auch andere im Wesentlichen flächig ausgebildete Gegenstände, wie Platinen, Behälter, Halbzeuge, denkbar. Die zu reinigenden Gegenstände können auch in einem Carrier oder einem Waschrahmen fixiert sein, der dann wiederum in die entsprechende Halterung eingesetzt wird. Sofern die erfindungsgemäße Vorrichtung nur zum Trocknen dient, werden die in Rede stehenden Gegenstände in einer separaten Vorrichtung zuvor gereinigt und anschließend gespült, woraufhin dann die Trocknung in der in Rede stehenden Vorrichtung erfolgt. Selbstverständlich ist es auch möglich, dass in der Vorrichtung alle drei Schritte, d.h. Reinigung, Spülung und Trocknung durchgeführt werden.

Aufgrund der Anordnung der Gegenstände in Reinigungskörben, was vergleichbar mit der Anordnung von Geschirr in einer Geschirrspülmaschine ist, ist die Anwendung des Trocknungsprinzips der Verdunstungstrocknung von Vorteil. Bei bekannten Vorrichtungen befindet sich in dem Trocknungslufteinlass als Luftfördereinrichtung ein Turbolüfter sowie als Heizeinrichtung ein dahinter geschaltetes leistungsstarkes Heizregister, um bei einer Vorrichtung, deren Prozesskammer in etwa die gleichen Abmessungen wie das Innengehäuse einer herkömmlichen Geschirrspülmaschine hat, einen erforderlichen Volumenstrom für Trocknungsluft, der vorzugsweise bei 100 bis 150 m³/h liegt, bei einer Mischtemperatur in der Prozesskammer von etwa 70 bis 100°C zu erzielen. Derartige Vorrichtungen weisen einen verhältnismäßig hohen Energiebedarf auf und sind auch in der Herstellung kostenintensiv und bauen mechanisch groß auf.

**Aus der** WO 93/01892 A1 **ist eine Lackier- und Trocknungskabine** mit allen Merkmalen des Oberbegriffs des Anspruchs 1 **bekannt, in der mit Wasserlack behandelte Fahrzeuge getrocknet werden.**

Aufgabe der Erfindung ist es, die vorgenannten Nachteile zu vermeiden und eine Vorrichtung anzugeben, die kostengünstiger ist und energiesparender arbeitet sowie kleiner aufbaut.

Diese Aufgabe wird dadurch gelöst, dass der Trocknungslufteinlass für die Heißluft und der weitere Trocknungslufteinlass für die Umgebungsluft zu einer Einheit zusammengefasst sind, wobei diese beiden Trocknungslufteinlässe koaxial angeordnet sind.

Im Mischbereich vermischt sich die heiße Heißluft und die über den weiteren Trocknungslufteinlass eingeleitete Umgebungsluft, die üblicherweise Raumluft aufweist, zu der Trocknungsluft. Über den jeweiligen Volumenstrom an Heißluft bzw. an Umgebungsluft kann die gewünschte Temperatur und die der Prozesskammer dann zugeführte gewünschte Menge an Trocknungsluft eingestellt werden.

Bei einer Ausführungsform kann in dem Trocknungsluftauslass ein Absaugventilator vorgesehen werden, der die Trocknungsluft aus der Prozesskammer absaugt. Durch das Absaugen der Trocknungsluft wird über den weiteren Trocknungslufteinlass Umgebungsluft in den Mischbereich angesaugt, die sich hier mit der durch die Heizeinrichtung erhitzten Heißluft zu einer entsprechend temperierten Trocknungsluft vermischt.

Selbstverständlich ist es auch möglich, dass in zumindest einem Trocknungslufteinlass ein Einlassventilator vorgesehen ist, der die Heißluft und/oder die Umgebungsluft in die Prozesskammer einbläst und die Trocknungsluft aus der Prozesskammer durch den Trocknungsluftauslass hinausdrückt.

Selbstverständlich sind auch Kombinationen denkbar, bei denen beispielsweise in dem Trocknungsluftauslass ein Absaugventilator und in zumindest einem der beiden Trocknungslufteinlässe ein Einblasventilator vorgesehen sind.

Der Trocknungslufteinlass für die Heißluft und der weitere Trocknungslufteinlass für die Umgebungsluft sind zu einer Einheit zusammengefasst, wobei diese beiden Trocknungslufteinlässe koaxial angeordnet sind. Sofern die beiden Trocknungslufteinlässe koaxial angeordnet sind, ist vorzugsweise der Trocknungslufteinlass für die Umgebungsluft ringförmig ausgebildet und erstreckt sich um den Trocknungslufteinlass für die Heißluft. Dabei kann der Ring rund oder auch eckig ausgebildet sein. Auch kann der Ring außen eine andere Form als innen aufweisen.

Bei einem bevorzugten Ausführungsbeispiel ist als Heizeinrichtung ein Heißluftgebläse vorgesehen. Es sind aber auch andere Ausgestaltungen denkbar.

Vorzugsweise kann eine den Volumenstrom durch die Heizeinrichtung beeinflussende Einrichtung, insbesondere eine als verschwenkbar und/oder drehbar angeordnete Klappe ausgebildete Einrichtung, vorgesehen sein. Hierdurch kann der der Heizeinrichtung zugeführte Volumenstrom verändert werden. Die Einrichtung ist vorzugsweise in Strömrichtung gesehen, der Heizeinrichtung vorgelagert. Die Schwenkachse ist bezogen auf die Klappe zumindest in etwa mittig angeordnet, so dass die Klappe in zwei, in etwa gleich große Klappenblatthälften unterteilt wird.

Ferner bietet sich an, wenn eine den Volumenstrom durch den weiteren Trocknungslufteinlass beeinflussende Einrichtung, insbesondere eine als verschwenkbar und/oder drehbar angeordnete Klappe ausgebildete Einrichtung, vorgesehen ist. Hierdurch kann der durch den weiteren Trocknungslufteinlass zugeführte Volumenstrom verändert werden.

Auch kann eine den Volumenstrom durch den Trocknungsluftauslass beeinflussende Einrichtung, insbesondere eine als verschwenkbar und/oder drehbar angeordnete Klappe ausgebildete Einrichtung, vorgesehen sein. Hierdurch kann der durch den Trocknungsluftauslass strömenden Volumenstrom verändert werden.

Selbstverständlich ist es auch möglich, dass der Querschnitt des Trocknungsluftauslasses und/oder zumindest eines Trocknungslufteinlasses unveränderbar ist. Dies bietet sich an, wenn die Vorrichtung auf bestimmte Prozessparameter, z.B, hinsichtlich der Volumenstrommenge an Trocknungsluft, eingestellt ist, die später auch nicht verändert werden sollen.

Der Mischbereich kann zumindest im Wesentlichen im kanalartig ausgebildeten und vor dem Übergang in die Prozesskammer befindlichen Trocknungslufteinlass angeordnet sein. Da die Mischung von Heiß- und Umgebungsluft zu Trocknungsluft noch in dem Trocknungslufteinlass selbst stattfindet, wird in die Prozesskammer direkt die Trocknungsluft mit der gewünschten Temperatur eingeleitet.

Das Gehäuse kann aus mehreren Gehäuseteilen bestehen, wobei vorzugsweise ein Gehäuseteil als Tür ausgebildet ist. Üblicherweise besteht das Gehäuse aus 6 Gehäuseteilen, wobei vier Gehäuseteile die Seitenwände sowie zwei gegenüberliegende Gehäuseteile den Boden und den Deckel bilden.

Zumindest ein Trocknungslufteinlass und der Trocknungsluftauslass können nebeneinander, insbesondere in einem gemeinsamen Gehäuseteil, angeordnet sein.

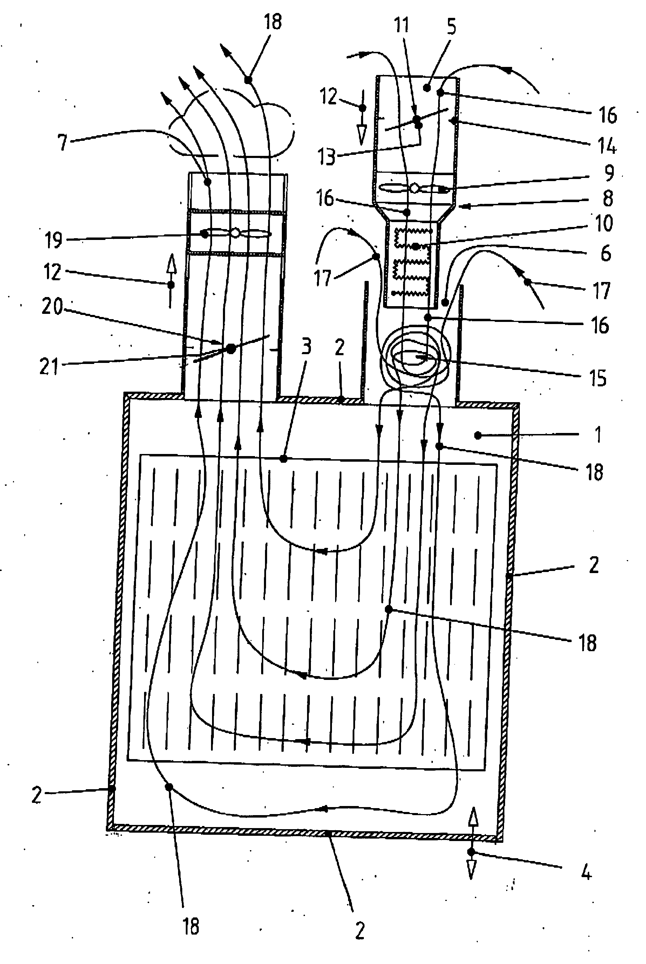

Im Folgenden wird ein in der Zeichnung dargestelltes Ausführungsbeispiel der Erfindung erläutert. Die einzige Figur zeigt einen horizontalen Schnitt durch eine erfindungsgemäße Vorrichtung.

Die Vorrichtung besteht aus einem eine Prozesskammer 1 bildenden Gehäuse mit vier seitlichen Gehäuseteilen 2 sowie einem unterseitigen und oberseitigen Gehäuseteil 2. Die Abmessungen der Prozesskammer 1 entsprechen in etwa den Abmessungen des Innengehäuses einer herkömmlichen Geschirrspülmaschine. Die Prozesskammer 1 hat etwa eine Breite von etwa 55 cm, eine Höhe von etwa 60 cm und eine Tiefe von etwa 50 cm.

Ein Gehäuseteil 2 ist als Tür ausgebildet. Die Tür ist schwenkbar an den zwei benachbarten Gehäuseteilen 2 angebracht. Hierzu ist eine nicht dargestellte horizontale Schwenkachse wie bei einer herkömmlichen Geschirrspülmaschine vorgesehen. In dem Gehäuse ist ein Reinigungskorb 3 angedeutet, der nach Öffnen der Tür in Richtung des Pfeils 4 aus der Prozesskammer 1 hinaus- und wieder hineingeschoben werden kann.

In dem Gehäuseteil 2, das dem als Tür ausgebildeten Gehäuseteil 2 gegenüberliegt,sind ein Trocknungslufteinlass 5, ein weiterer Trocknungslufteinlass 6 sowie in geringem Abstand daneben ein Trocknungsluftauslass 7 vorgesehen.

Bei dem dargestellten Ausführungsbeispiel sind der Trocknungslufteinlass 5 für Heißluft 16 und der weitere Trocknungslufteinlass 6 für Umgebungsluft 17 zu einer Einheit zusammengefasst, wobei die beiden Trocknungslufteinlässe 5, 6 koaxial angeordnet sind. So umfasst der weitere Trocknungslufteinlass 6 für die Umgebungsluft 17 ringförmig den Trocknungslufteinlass 5 für die Heißluft 16.

In dem Trocknungslufteinlass 5 für die Heißluft 16 ist eine Heizeinrichtung 8, bestehend aus einem Ventilator 9 und einer Heizspirale 10, angeordnet. Bei der Heizeinrichtung 8 handelt es sich um ein Heißluftgebläse, das bei einer Leistungsaufnahme von etwa 3,7 KW eine Heißluftmenge von etwa 30 m³/h mit einer Temperatur von 600°C liefert. Der Trocknungslufteinlass 6 kann einen Eintrittsquerschnitt von z.B. 140 x 140 mm aufweisen, wobei der Durchmesser der Heizeinrichtung 8 etwa 60 bis 65 mm beträgt.

Der Heizeinrichtung 8 vorgeschaltet ist eine Einrichtung 11, um den Volumenstrom durch die Heizeinrichtung 8 zu beeinflussen. Diese ist vorliegend als Klappe ausgebildet, die um eine quer zur Strömungsrichtung 12 ausgerichtete Schwenkachse 13 schwenkbar oder drehbar gelagert ist und in der Schließstellung mit Anschlägen 14 in Kontakt ist. In dem dargestellten Ausführungsbeispiel ist die Einrichtung 11 mit der Klappe und der Schwenkachse 13 in die Heizeinrichtung 8 integriert, so dass die Heizeinrichtung 8 und die Einrichtung 11 eine Einheit bilden. Es ist aber auch durchaus möglich, dass die Heizeinrichtung 8 und die Einrichtung 11 separate Bauteile darstellen.

An die beiden Trocknungslufteinlässe 5, 6 schließt sich ein Mischbereich 15 an, in dem die Heißluft 16 und die Umgebungsluft 17 zu Trocknungsluft 18 vermischt werden. Bei dem dargestellten Ausführungsbeispiel ist der Mischbereich 15 im kanalartig ausgebildeten und vor dem Übergang in die Prozesskammer 1 befindlichen Trocknungslufteinlass 5, 6 angeordnet.

Im Trocknungsluftauslass 7 ist ein Absaugventilator 19 vorgesehen. Der Absaugventilator 19 ist so ausgerichtet, dass etwa 130 m³ Trocknungsluft 18 aus der Prozesskammer 1 abgesaugt werden. Durch dieses Absaugen wird nicht nur die Trocknungsluft 18 aus der Prozesskammer 1 abgesaugt, sondern auch durch den weiteren Trocknungslufteinlass 6 nach Art eines Venturiprinzips Umgebungsluft 17 in den Mischbereich 15 angesaugt. Hier findet die Vermischung der Umgebungsluft 17 mit der Heißluft 16 statt. Da der Mischbereich 15 in dem Trocknungslufteinlass 5, 6, d.h. noch vor dem Ubergang in die Prozesskammer 1, liegt, strömt in die Prozesskammer 1 bereits ein gemischter Trocknungsluftstrom 18 von ca. 130 m³ mit 70° ein.

Bei dem dargestellten Ausführungsbeispiel ist in dem Trocknungsluftauslass 7 dem Absaugventilator 19 vorgeschaltet noch eine Einrichtung 20 zur Beeinflussung des durch den Trocknungsluftauslass 7 strömenden Volumenstroms angeordnet. Bei der Einrichtung 20 handelt es sich ebenfalls um eine Klappe, die um eine quer zur Strömungsrichtung 12 ausgerichtete Schwenkachse 21 schwenkbar gelagert ist.

## Patentansprüche

1. Vorrichtung zur Trocknung, insbesondere zur vorherigen Reinigung, Spülung und anschließenden Trocknung, von im Wesentlichen flächigen Gegenständen, mit einem eine Prozesskammer (1) bildenden Gehäuse, das zumindest einen Trocknungslufteinlass (5) und zumindest einen Trocknungsluftauslass (7) aufweist, mit wenigstens einer Heizeinrichtung (8) und mit wenigstens einer Luftfördereinrichtung, wobei zumindest eine Heizeinrichtung (8) im Bereich eines Trocknungslufteinlasses (5) vorgesehen ist, dass ein weiterer Trocknungslufteinlass (6), über den Umgebungsluft (17) unter Umgehung der Heizeinrichtung (8) in die Prozesskammer (1) einleitbar, insbesondere ansaugbar, vorgesehen ist, dass ein sich an diese beiden Trocknungslufteinlässe (5, 6) anschließender Mischbereich (15) vorgesehen ist, in dem die durch den weiteren Trocknungslufteinlass (6) angesaugte Umgebungsluft (17) und die von der Heizeinrichtung (8) erhitzte Heißluft (16) zu Trocknungsluft (18) vermischt werden, und dass in zumindest einem Trocknungsluftauslass (7) und/oder in zumindest einem der beiden Trocknungslufteinlässe (5, 6) eine als Absaugventilator (19) bzw. als Einblasventilator ausgebildete Luftfördereinrichtung zum Absaugen der Trocknungsluft (18) bzw. zum Einblasen der Heißluft (16) bzw. der Umgebungsluft (17) angeordnet ist (sind) , **dadurch gekennzeichnet, dass** der Trocknungslufteinlass (5) für die Heißluft (16) und der weitere Trocknungslufteinlass (6) für die Umgebungsluft (17) zu einer Einheit zusammengefasst sind, wobei diese beiden Trocknungslufteinlässe (5, 6) koaxial angeordnet sind.

2. Vorrichtung nach dem vorhergehenden Anspruch **dadurch gekennzeichnet, dass** als Heizeinrichtung (8) ein Heißluftgebläse vorgesehen ist.

3. Vorrichtung nach einem der vorhergehenden Ansprüche, **dadurch gekennzeichnet, dass** eine den Volumenstrom durch die Heizeinrichtung (8) beeinflussende Einrichtung (11), insbesondere eine als verschwenkbar und/oder drehbar angeordnete Klappe ausgebildete Einrichtung (11), vorgesehen ist.

4. Vorrichtung nach einem der vorhergehenden Ansprüche, **dadurch gekennzeichnet, dass** eine den Volumenstrom durch den weiteren Trocknungslufteinlass (6) beeinflussende Einrichtung, insbesondere eine als verschwenkbar und/oder drehbar angeordnete Klappe ausgebildete Einrichtung, vorgesehen ist.

5. Vorrichtung nach einem der vorhergehenden Ansprüche, **dadurch gekennzeichnet, dass** eine den Volumenstrom durch den Trocknungsluftauslass (7) beeinflussende Einrichtung (20), insbesondere eine als verschwenkbar und/oder drehbar angeordnete Klappe ausgebildete Einrichtung (20), vorgesehen ist.

6. Vorrichtung nach einem der vorhergehenden Ansprüche, **dadurch gekennzeichnet, dass** der Mischbereich (15) zumindest im Wesentlichen im kanalartig ausgebildeten und vor dem Übergang in die Prozesskammer (1) befindlichen Trocknungslufteinlass (5, 6) angeordnet ist.

7. Vorrichtung nach einem der vorhergehenden Ansprüche, **dadurch gekennzeichnet, dass** das Gehäuse aus mehreren Gehäuseteilen (2) besteht und vorzugsweise ein Gehäuseteil (2) als Tür ausgebildet ist.

8. Vorrichtung nach einem der vorhergehenden Ansprüche, **dadurch gekennzeichnet, dass** zumindest ein Trocknungslufteinlass (5, 6) und der Trocknungsluftauslass (7) nebeneinander, insbesondere in einem gemeinsamen Gehäuseteil (2), angeordnet sind.

## Claims

1. Device for drying, in particular for prior cleaning, rinsing and subsequent drying, of essentially flat objects, including a housing forming a process chamber (1), which comprises at least one drying air inlet (5) and at least one drying air outlet (7), with at least one heating device (8) and with at least one air conveying device, wherein at least one heating device (8) is provided in the area of a drying area inlet (5), that a further drying air inlet (6) is provided, by means of which ambient air (17) can be conducted into the process chamber (1), bypassing the heating device (8), in particular by suction, that, following on from these two drying air inlets (5, 6), a mixing area (15) is provided, in which the ambient air (17) sucked in through the further drying air inlet (6) and the hot air (16) heated by the heating device (8) is mixed with the drying air (18), and that, arranged in at least one drying air outlet (7) and/or in at least one of the two drying air outlet inlets (5, 6), is an air conveying device, formed as a suction fan (19) or as a blow-in fan, for suctioning out the drying air (18) or for blowing in the hot air (16) or the ambient air respectively (17), **characterized in that** the drying air inlet (5) for the hot air (16) and the further drying air inlet (6) for the ambient air (17) are merged to one unit, wherein these two drying air inlets (5, 6) are arranged coaxially.

2. Device according to the preceding claim, **characterised in that** a hot-air fan is provided as the heating device (8).

3. Device according to any one of the preceding claims, **characterised in that** a device (11) is provided for influencing the volume flow through the heating device (8), in particular a device (11) formed as a flap capable of pivoting and/or rotating.

4. Device according to any one of the preceding claims, **characterised in that** a device is provided for influencing the volume flow through the further drying air inlet (6), in particular a device formed as a flap capable of pivoting and/or rotating.

5. Device according to any one of the preceding claims, **characterised in that** a device (20) is provided for influencing the volume flow through the further drying air outlet (7), in particular a device (20) formed as a flap capable of pivoting and/or rotating.

6. Device according to any one of the preceding claims, **characterised in that** the mixing area (15) is arranged at least essentially in the drying air inlet (5, 6) formed in the manner of a channel and located upstream of the transition into the process chamber (1).

7. Device according to any one of the preceding claims, **characterised in that** the housing consists of several housing parts (2), and preferably one housing part (2) is formed as a door.

8. Device according to any one of the preceding claims, **characterised in that** at least one drying air inlet (5, 6) and the drying air outlet (7) are arranged next to one another, in particular in a joint housing part (2).

## Revendications

1. Dispositif de séchage, en particulier de nettoyage et de rinçage préalables puis de séchage, d'objets essentiellement plats, avec un carter qui forme une chambre de traitement (1) et qui présente au moins une entrée (5) d'air de séchage et au moins une sortie (7) d'air de séchage, avec au moins un équipement de chauffage (8) et avec au moins un équipement de circulation d'air, sachant qu'au moins un équipement de chauffage (8) est prévu dans la région d'une entrée (5) d'air de séchage , sachant qu'il est prévu une entrée supplémentaire (6) d'air de séchage, par laquelle de l'air ambiant (17) peut être introduit, notamment aspiré dans la chambre de traitement (1) en contournant l'équipement de chauffage (8), sachant qu'il est prévu une zone de mélangeage (15) qui fait suite à ces deux entrées (5, 6) d'air de séchage et dans laquelle l'air ambiant (17) aspiré par l'entrée supplémentaire (6) d'air de séchage et l'air chaud (16) chauffé par l'équipement de chauffage (8) sont mélangés pour former de l'air de séchage (18), et sachant qu'un ou des équipements de circulation d'air respectivement réalisés sous forme de ventilateur (19) d'évacuation par aspiration ou de ventilateur d'admission par aspiration est ou sont disposés dans au moins une sortie (7) d'air de séchage et/ou dans au moins une des deux entrées (5, 6) d'air de séchage, respectivement pour l'évacuation par aspiration de l'air de séchage (18) ou pour l'admission par aspiration de l'air chaud (16) ou respectivement de l'air ambiant (17), **caractérisé en ce que** l'entrée (5) d'air de séchage pour l'air chaud (16) et l'entrée supplémentaire (6) d'air de séchage pour l'air ambiant (17) sont regroupées en une unité, sachant que ces deux entrées (5, 6) d'air de séchage sont disposées coaxialement.

2. Dispositif selon la revendication précédente, **caractérisé en ce qu'**une soufflante à air chaud est prévue comme équipement de chauffage (8).

3. Dispositif selon l'une des revendications précédentes, **caractérisé en ce qu'**il est prévu un équipement (11) agissant sur le débit volumique à travers l'équipement de chauffage (8), en particulier un équipement (11) réalisé sous forme de volet disposé à pivotement et/ou à rotation.

4. Dispositif selon l'une des revendications précédentes, **caractérisé en ce qu'**il est prévu un équipement agissant sur le débit volumique à travers l'entrée supplémentaire (6) d'air de séchage, en particulier un équipement réalisé sous forme de volet disposé à pivotement et/ou à rotation.

5. Dispositif selon l'une des revendications précédentes, **caractérisé en ce qu'**il est prévu un équipement (20) agissant sur le débit volumique à travers la sortie (7) d'air de séchage, en particulier un équipement (20) réalisé sous forme de volet disposé à pivotement et/ou à rotation.

6. Dispositif selon l'une des revendications précédentes, **caractérisé en ce que** la zone de mélangeage (15) est disposée au moins pour l'essentiel dans l'entrée (5, 6) d'air de séchage, réalisée du genre canal et se trouvant avant le passage dans la chambre de traitement (1).

7. Dispositif selon l'une des revendications précédentes, **caractérisé en ce que** le carter est constitué de plusieurs parties de carter (2) et, de préférence, une partie de carter (2) est réalisée sous forme de porte.

8. Dispositif selon l'une des revendications précédentes, **caractérisé en ce qu'**au moins une entrée (5, 6) d'air de séchage et la sortie (7) d'air de séchage sont disposées l'une à côté de l'autre, en particulier dans une partie de carter commune (2).
